Europäisches Patentamt

European Patent Office

Office européen des brevets

(19)

(11) **EP 1 130 718 A2**

(12) # EUROPEAN PATENT APPLICATION

(43) Date of publication:
**05.09.2001 Bulletin 2001/36**

(51) Int Cl.7: **H01S 5/14**

(21) Application number: **01300491.6**

(22) Date of filing: **19.01.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **20.01.2000 US 177405 P**

(71) Applicant: **Cyoptics (Israel) Ltd.**
**Yokneam Illit 20692 (IL)**

(72) Inventor: **Zimmermann, Micha**
**Haifa 34352 (IL)**

(74) Representative: **Evens, Paul Jonathan et al**
**Maguire Boss,**
**5 Crown Street**
**St. Ives, Cambridge PE27 5EB (GB)**

(54) **Tunable frequency stabilized fiber grating laser**

(57)    A laser, including a grating structure (88) having two or more gratings (88A, 88B, 88C, 88D) having a plurality of different wavelength peaks for reflection of optical radiation therefrom. The laser further includes a semiconductor device (72), having an active region (76) which is operative to amplify the optical radiation, and a reflective region (82), which is adapted to reflect the optical radiation at a tunable resonant wavelength of the reflective region, the device being optically coupled to the grating structure so as to define a laser cavity (84) having a single cavity mode defined by tuning the resonant wavelength of the reflective region to overlap with one of the wavelength peaks of the grating structure.

FIG. 5

**Description**

**CROSS-REFERENCE TO RELATED APPLICATIONS**

This application claims the benefit of U.S. Provisional Application 60/177, 405, filed January 20, 2000, which is assigned to the assignee of the present patent application and is incorporated herein by reference.

**FIELD OF THE INVENTION**

The present invention relates generally to lasers, and specifically to stabilization of lasers operating in multiple modes.

**BACKGROUND OF THE INVENTION**

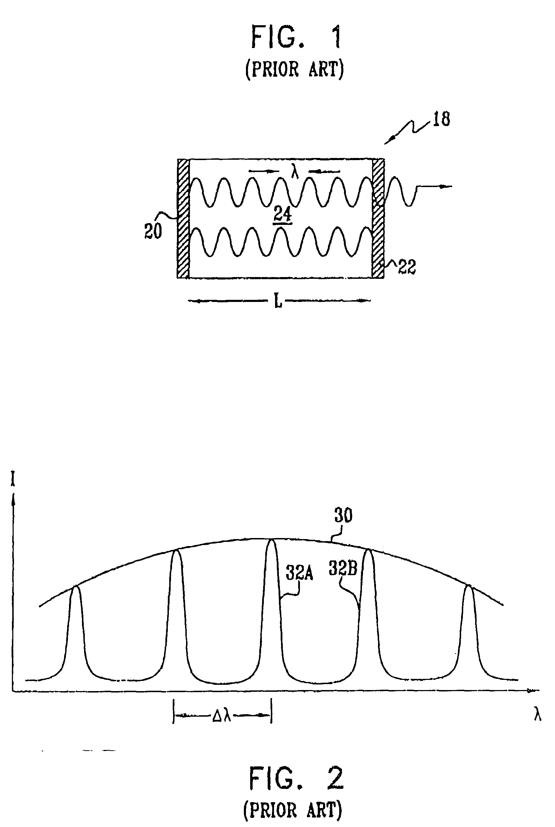

Fig. 1 is a schematic diagram showing operation of a lasing system 18, as is known in the art. System 18 comprises two mirrors 20 and 22 separated by a distance L. In order for system 18 to lase i.e., to resonate, at a wavelength $\lambda$, a medium 24 between mirrors 20 and 22 must provide gain, and an effective optical path length $L_{eff}$ between the mirrors must be an integral number of half-wave) engths. Quantitatively,

$$L_{eff} = nL \tag{1a}$$

so that

$$m \cdot \lambda/2 = nL \tag{1b}$$

or

$$f = m \cdot c/ (2nL) \tag{1c}$$

wherein m is a positive integer, n is a refractive index of medium 24, f is the frequency corresponding to the wavelength $\lambda$, and c is the speed of light.

From equation (1c), a separation $\Delta f$ of lasing frequencies is given by

$$\Delta f = c/(2nL) \tag{2}$$

Each such lasing frequency corresponds to a longitudinal cavity mode. Since $f = c/\lambda$, $\Delta f \cong - c \cdot \Delta\lambda/\lambda^2$ so that equation (2) can be rewritten to give a separation $\Delta\lambda$ of Lasing wavelengths:

$$\Delta\lambda \cong \lambda^2/ (2nL) \tag{3}$$

Fig. 2 is a graph of intensity I vs. wavelength $\lambda$ illustrating cavity modes for system 18, as is known in the art. A Curve 30 represents an overall gain of medium 24 in system 18. Peaks 32A and 32B, with separation $\Delta\lambda$, show the cavity modes present in system 18, each node corresponding to a different value of m. As is evident from Fig. 2, there are many possible cavity modes for system 18.

Optical communications within fiber optic links require that the laser carrier have as small a frequency spread as possible, particularly when multiple wavelengths are to be multiplexed on a single fiber. Thus, for efficient communication only one cavity mode should be used, and optimally the frequency spread within the mode should be minimized. Typically, methods for stabilizing the frequency of the laser include utilizing distributed feedback (DFB) lasers and/or distributed Bragg reflector (DBR) lasers. DFB lasers have a frequency-selection grating built into the laser chip, the grating being physically congruent with the gain modium. The grating in a DBR laser is external to the gain medium. The gratings in DFB and DBR lasers are part of the semiconductor material, which is unstable. DFB and DBR lasers are therefore typically externally stabilized utilizing an external wavelength reference in order to achieve good stability.

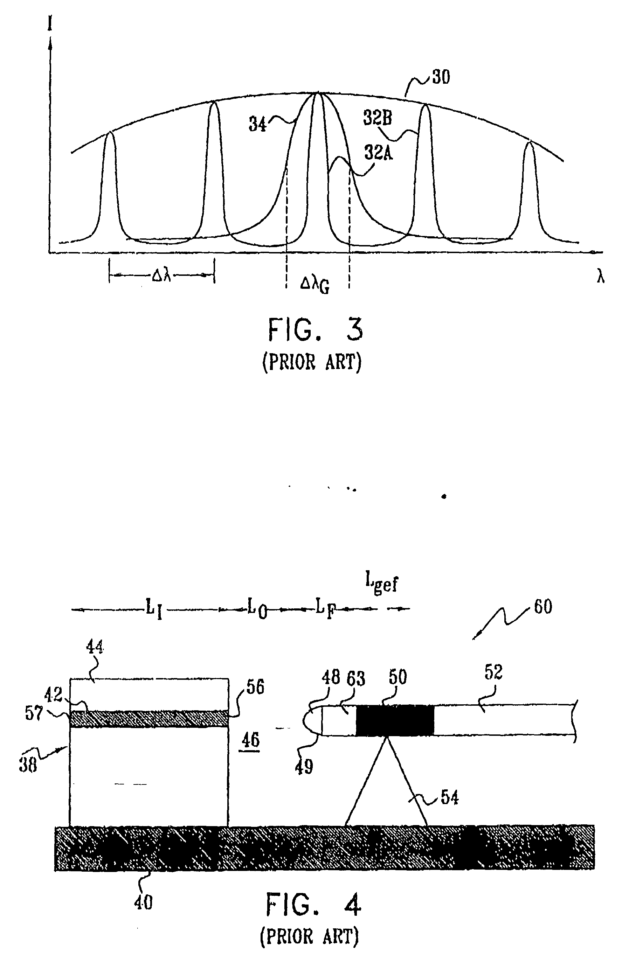

Fig. 3 shows the effect of adding a tuning element such as a fiber grating to system 18, as is known in the art. A curve 34 shows the resonance curve of the fiber grating, which has a bandwidth $\Delta\lambda_G$ of the same order as $\Delta\lambda$, the separation between the longitudinal cavity modes. If the grating is optically coupled to system 18, than mode 32A is present, and other modes such as mode 32B, are suppressed.

Fig. 4 is a schematic diagram showing a gain medium 38 coupled to a fiber grating 50, as is known in the art. Gain medium 38 is formed frcm a semiconductor. gain element 44 having a laser gain region 42. Light from region 42 exits from a facet 56 of region 42 to a medium 46, and traverses medium 46 so that a lens 48 collects the light into a fiber optic 52. Fiber grating 50 is mounted in fiber optic 52, which grating reflects light corresponding to curve 34 of Fig. 3 back to region 42. The mirrors of the laser cavity comprise a rear mirror which in this example is a back facet 57 of the semiconductor gain element, and an output coupling mirror which in this example is fiber grating 50. The rear and output coupling mirrors could also be reversed. In the reversed configuration the rear mirror would be the fiber grating and the output coupling mirror would be back facet 57 of the semiconductor gain element.

It is desirable to eliminate parasitic reflections clue to surfaces and interfaces internal to the cavity. To eliminate parasitic reflection from the facet of the semiconductor closest to the fiber grating, in this case facet 56, that facet is usually anti reflection coated. It is also useful to anti reflection coat a tip 49 of the fiber closest to the semiconductor gain element to again reduce parasitic reflections. Preferably, grating 50 is written directly at the end of the fiber optic facing the laser. Alternatively, a length $L_f$ of a fiber 63 is interposed between lens 48 and fiber optic grating 50. Thus region 42, medium 46, fiber optic 63 and grating 50 form a resonant system 60 corresponding to region 24 of Fig. 1. This architecture is generally known in the art as an external cavity laser or more specifically as a fiber grating laser (FGL).

System 60 has an effective optical path length $L_{eff}$ given by:

$$L_{eff} = n_1 \cdot L_1 + n_0 \cdot L_0 + n_f \cdot L_f + n_g \cdot L_{gef} \qquad (4)$$

wherein

$n_1$ is a refractive index of region 42;
$L_1$ is a length of region 42;
$n_0$ is a refractive index of medium 46;
$L_0$ is a length of medium 46;
$n_f$ is a refractive index of fiber 63;
$L_f$ is the length of fiber 63.
$n_g$ is a refractive index of grating 50; and
$L_{gef}$ is an effective length of grating 50.

Replacing the optical path length nL of equation (1b) by that given by equation (4) leads to the following equation giving cavity modes for the system of Fig. 3:

$$m\ \lambda/2 = (n_1 \cdot L_1 + n_0 \cdot L_0 + n_f \cdot L_f + n_g \cdot L_{gef}) \qquad (5)$$

In constructing system 60, it is necessary to adjust and maintain the positions of curve 32A and 34 (Fig, 3) to have their peaks at the same wavelength. Changes in temperature and/or changes in injection current into region 42 and/or mechanical changes affect one or more parameters of the optical path length given by equation (4). Such changes can thus cause mode hopping, which refers to the phenomena whereby mode 32A shifts underneath resonance curve 34 of the fiber grating. When that; shirt is large enough, an adjacent mode will at some point experience a larger gain and start to lase. These mode hops occur underneath the resonance curve of the fiber grating (curve 34 in Fig. 3) resulting in wavelength shifts and intensity noise when the mode hops. For example, referring to Fig. 3, mode 32B could shift within resonance curve 34 of the fiber grating and resonate instead of mode 32A.

An article titled "1.5-1,6 μm dynamic-single-mode (DSM) lasers with distributed Bragg reflector," by Koyama et al., in the Vol. 19 (1983) issue of *IEEE Journal of Quantum Electronics*, which is incorporated herein by reference, describes a method for tuning a DBR by injecting current.

Super structure grating (SSGs) are known in the art as structures which comprise a plurality of gratings distributed along a fiber in a manner such as to provide a spectral response with several peaks, An article titled "Long periodic superstructure Bragg gratings in optical fibers," by Eggleton et al., in the Vol, 30 (1994) issue of *Electronics Letters,* which is incorporated herein by reference, describes one such SSG, An SSG in a fiber provides a system having a plurality of relatively highly stable fixed wavelengths.

SSG systems have been implemented in semiconductor devices, to take advantage of the fact that when implemented therein the cavities so formed are tunable. An article titled "Theory, design and performance of extended tuning range semiconductor lasers with sampled gratings," by Jayaraman et al., in the Vol. 29 (1993) issue of *IEEE Journal of Quantum Electronics,* which is incorporated heroin by reference, describes two such systems which are tuned in a vernier-like manner. Unfortunately, due to the inherent characteristics of the semiconductor, SSG devices implemented in semiconductors are relatively unstable, as is also true for single wavelength DBRs implemented therein.

The information carrying capacity of a single lasing line can be increased by increasing the frequency of modulation of the laser. However such increased frequency widens the laser line width through chirp, which in turn reduces the transmission range due to dispersion. In order to circumvent the effects of dispersion, a method known in the art is to use wavelength division multiplexing (WDM) wherein a plurality of laser lines are each modulated at an intermediate bandwidth, The total bandwidth is then the number of laser lines multiplied by the intermediate bandwidth. For example, instead of modulating one line at 10 Gbit/s, four lines can each be modulated at 2.5 Gbit/s to provide the same information carrying capacity.

Standard ITU-T G. 692 of the International Telecommunications Union (ITU), Place des Nations CH-1211, Geneva 20, Switzerland, defines allowable wavelengths for WDM systems, so that systems implemented by different manufacturers will be compatible with each other. Systems known in the art for implementing WDM use a plurality of lasers, each having a different fixed wavelength corresponding to the ITU standard.

## SUMMARY OF THE INVENTION

It is an object of some aspects of the present invention to provide improved methods and apparatus for generating a plurality of laser wavelengths,

In preferred embodiments of the present invention, a semiconductor device comprises an active gain region and a distributed Bragg reflector (DBR), which acts as a first, highly-reflecting mirror at one end of a laser cavity that contains the gain region. The DBR is tuned by, most preferably, varying a current injected into the DBR. The active gain region is coupled at the side opposite the DBR to a fiber optic comprising a super structure grating (FO-SSG) having a plurality of relatively highly stable resonant peaks, the peaks most preferably being separated substantially equidistantly. The FO-SSG acts as a second, partially-reflecting mirror at. the other end of the laser cavity. An output of the cavity is derived from light transmitted by the FO-SSG into the fiber optic.

To operate the laser, the gain region is activated, and the DBR is tuned so that a resonant peak of the DRR is aligned with one of the resonant peaks of the FO-SSG. Thus, the laser resonates in a single cavity mode defined by the two resonant peaks, and all other modes are substantially suppressed. By scanning the tuning of the DBR over the range of the FO-SSG, all the different resonant peaks of the FO-SSG may be selected at will, producing corresponding single cavity modes. Coupling a DBR with an FO-SSG combines the advantages of tunability associated with the DRE and stability associated with the FO-SSG for all modes of the cavity. Preferred embodiments of the present invention thus enable a single laser to be used as a generator in a WDM system.

In some preferred embodiments of the present invention, the DBR is written as a super structure grating (DBR-SSG) within the semiconductor device. The spacing of peaks of the DBR-SSG is implemented to be slightly different from the spacing of the peaks of the FO-SSG. The cavity produced by the combination of the DBR-SSG with the FO-SSG is then tuned in a vernier-like manner, by setting one of the peaks or the DBR-SSG to align with one of the peaks of the FO-SSG. Because of the vernier-like spacing relationship between the two SSGs, all other peaks, apart from the aligned pair, are misaligned, so that only one mode defined by the aligned pair resonates and all other modes are suppressed. All the resonant peaks of the FO-SSG may be selected by scanning the DBR-SSG over a range that is substantially the same as the spacing of two peaks of the DBR-SSG.

In some preferred embodiments of the present invention, the laser cavity is stabilized by thermally modulating one or more optical elements, and/or parameters thereof, so as to vary an effective length of the cavity. A method of thermal modulation is described in detail in PCT patent application PCT/IL00/00401, which is assigned to the assignee of the present invention and which is incorporated herein by reference. The modulation generates an error signal which is dependent on a relationship of the oscillating mode with resonant frequency of the cavity, and the error signal is used in a nogative feedback loop to ensure that the mode and resonant frequency substantially coincide.

There is therefore provided, according to a preferred embodiment of the present invention, a laser, including:

a grating structure, including two or more gratings having a plurality of different wavelength peaks for reflection of optical radiation therefrom; and

a semiconductor device, including an active region, which is operative to amplify the optical radiation, and a reflective region, which is adapted to reflect the optical radiation at a tunable resonant wavelength of the reflective region, the device being optically coupled to the grating structure so as to define a laser cavity having a single cavity mode defined by tuning the resonant wavelength of the reflective region to overlap with one of the wavelength peaks of the grating structure.

Preferably, the grating structure includes a super structure grating (SSG) written in a fiber optic.

Preferably, fiber optic includes a lens which focuses optical radiation from the semiconductor device to the grating structure.

Preferably, the two or more gratings are adapted to partially transmit optical radiation at the different wavelengths, so as to provide output optical radiation.

Preferably, the reflective region includes a Distributed Bragg Reflector (DBR) written onto the semiconductor device, wherein the resonant wavelength of the reflective region is tuned by a current injected into the DBR.

Preferably, the plurality of different wavelength peaks are substantially equidistantly spaced by a first separation, wherein the reflective region includes a Distributed Bragg Reflector with a super structure grating (DBR-SSG) having a plurality of different wavelength peaks substantially equidistantly spaced by a second separation different from the first separation, so that the first separation is related to the second separation in a vernier-like manner and so that the single cavity mode is defined when one of the grating structure wavelength peaks overlaps with one of the DBR-SSG wavelength peaks

Preferably, the laser includes:

an optical length changer which varies an optical length of at least one of a group of optical elements including the grating structure the active region and the reflective region, so as to vary accordingly an optical length of the laser cavity;

a detector which is adapted to monitor a level of the optical radiation responsive to the variation in the optical length of the at least one of the group; and

a stabilizer which responsive to the measured output from the detector supplies a control signal to the optical length changer to control an optical length of at least one of the group, so that the laser cavity resonates stably in the single cavity mode.

Further preferably, the optical length changer includes at least one of a thermally active group comprising a heater and a thermoelectric cooler, wherein the at least one of the thermally active group is adapted to alter a temperature of at least one of the group of optical elements.

There is further provided, according to a preferred embodiment of the present invention, a method. for generating a laser output, including:

providing a grating structure having a plurality of different wavelength peaks for reflection of optical radiation therefrom;

optically coupling a semiconductor device to the structure so as to define a laser cavity between the structure and a reflective region of the device, which is adapted to reflect the optical radiation at a tunable resonant wavelength of the reflective region; and

tuning the resonant wavelength of the reflective region to overlap with one of the wavelength peaks of the grating structure so as to generate a laser output in a single cavity mode defined by the overlap.

Preferably, providing the grating structure includes writing a super structure grating (SSG) in a fiber optic.

Preferably, providing the grating structure includes providing two or more gratings which are adapted to partially transmit optical radiation at the different wavelength peaks, so as to provide output optical radiation.

Preferably, the reflective region includes a Distributed Bragg Reflector (DBR) written onto the semiconductor device, wherein tuning the resonant wavelength of the reflective region includes injecting a current into the DBR.

Preferably, the reflective region includes a Distributed Bragg Reflector with a super structure grating (DBR-SSG) having a plurality of different, rospective DBR-SSG wavelength peaks substantially equidistantly spaced by a first separation, wherein providing the grating structure includes substantially equidistantly spacing the plurality of different wavelength peaks by a second separation different from the first separation and related to the first separation in a vernier-like manner, and wherein tuning the resonant wavelength includes overlapping one of the grating structure wavelength peaks with one of the DBR-SSG wavelength peaks

Preferably the method includes:

varying with an optical length changer an optical length of at least one of a group of optical elements including the grating structure, an active region of the semiconductor device, and the reflective region, so as to vary accordingly an optical length of the laser cavity;

monitoring a level of the optical radiation responsive to the variation in the optical length of the at least one of the group; and

supplying a control signal to the optical length changer responsive to the monitored level so as to control an optical length of at least one of the group, so that the laser cavity resonates stably in the single cavity mode.

Further preferably, varying the optical length includes altering a temperature of at least one of the group of optical elements using at least one of a thermally active group comprising a heater and a thermoelectric cooler.

The present invention will be more fully understood from the following detailed description of the preferred embodiments thereof, taken together with the drawings, in which:

**BRIEF DESCRIPTION OF THE DRAWINGS**

Fig. 1 is a schematic diagram showing operation of a laser system, as is known in the art;

Fig. 2 is a graph of intensity vs. wavelength, illustrating cavity modes for the system of Fig. 1, as is known in the art;

Fig. 3 shows the effect of adding a spectrally selective element such as a fiber grating to the system of Fig. 1, as is known in the art;

Fig. 4 is a schematic diagram showing a semiconductor gain medium coupled to a fiber grating forming a fiber grating laser (FGL), as is known in the art;

Fig. 5 is a schematic diagram of a laser system, according to a preferred embodiment of the present invention;

Fig. 6 shows schematic graphs of intensity vs. wavelength relationships for different elements of the system of Fig. 5, according to a preferred embodiment of the present invention;

Fig. 7 is a schematic diagram of a laser system, according to an alternative preferred embodiment of the present invention;

Fig. 8 shows schematic graphs of intensity vs. wavelength relationships for different elements of the system of Fig. 7, according to a preferred embodiment of the present invention; and

Fig. 9 is a schematic diagram of apparatus for locking a longitudinal mode of the system of Fig. S to a super structure grating peak, according to a preferred embodiment of the present invention.

**DETAILED DESCRIPTION OF PREFERRED EMBODIMENTS**

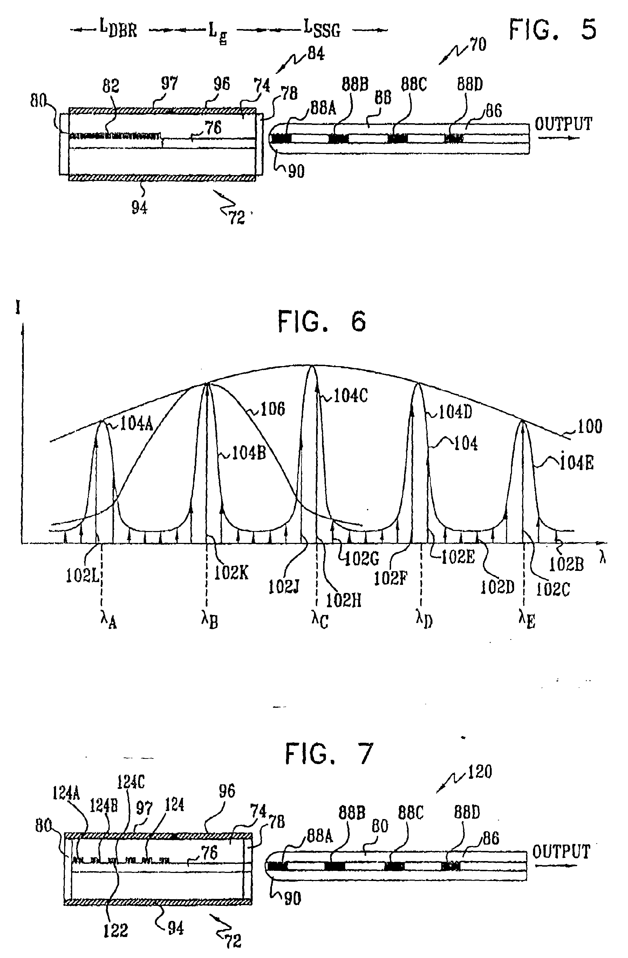

Reference is now made to Fig. 5, which is a schematic diagram of a laser system 70, according to a preferred embodiment of the present invention. A semiconductor device 72 comprises a gain medium 74, within which is formed a laser gain region 76 which acts as an active region amplifying optical radiation, Device 72 is generally box-shaped, and has front and back facets 78 and 80 which are most preferably anti-reflection coated in order to eliminate parasitic reflections within region 76. Adjacent to facet 80, region 76 comprises a Distributed Bragg Reflector (DBR) section 82, which is written onto device 72 by a photolithographic technique, as is known in the art. Distributed Bragg Reflector (DBR) section 82 has a relatively broad spectral response curve. The relationship between the curve of DBR 82 anti resonant: curves of other elements of system 70 is described below with reference to Fig. 6, During operation of system 70, DBR section 82 acts as a reflective region which is a substantially fully reflecting first mirror of a resonant cavity 84.

Cavity 84 also comprises a fiber optic 86, the fiber optic most preferably supporting single mode transmission. Fiber optic 86 comprises a super structure grating (SSG) 88 which is written in the fiber optic. SSG 88 acts as a grating structure which is implemented to have a plurality of gratings 88A, 88B, 88C, ..., with dead zones in between. The gratings may be of different lengths as may be the dead zones. The plurality of gratings 88A, 88B, 88C, ... and dead zones of SSG 88 provide a device with several spectral reflection features as will be described below. If system 70 is to be used in a wavelength division multiplexing (WDM) system, these spectral reflection features are most preferably written to correspond to wavelengths of the WDM system. Fiber optic 86 is coupled to device 72 by methods known in the art, for example, by using a lens 90 between the fiber optic and device 72 or by butting the fiber optic to facet 78. Preferably, if the fiber optic is butted to device 72, the device comprises a mode converter for better collection efficiency between the semiconductor and the fiber. The mode converter is most preferably implemented in the semiconductor, preferably by an architecture known in the art as a taper. SSG 88 acts as a partially reflecting second mirror of cavity 84, so that light transmitted through the SSG into fiber optic 86 is output light of system 70.

Device 72 comprises a first upper electrode 96 and a second upper electrode 97. Electrode 96 and lower electrode 94 are used to inject current into region 74 in order to cause region 76 to lase. Current injected via electrode 97 is varied so as to tune DBR section 82, by methods known in the art.

Fig. 6 shows schematic graphs of intensity vs, wavelength relationships for different elements of system 70, according to a preferred embodiment of the present invention. A graph 100 corresponds to a fundamental gain curve of device 72, according to the composition of the device. As described above in the Background of the Invention with reference to equations (1b), (2), and (3), cavity 84 has longitudinal cavity modes 102A, 102B, 102C, ... separated by $\Delta\lambda$, with wavelengths which are a function of an optical length between the mirrors of the cavity and the number of half-wavelengths comprising the mode. A graph 104 corresponds to the overall spectral reflection features of SSG 88, wherein each peak 104A, 104B, 104C, ... of the graph is a relatively narrow resonant curve. Most preferably, each resonant curve is sufficiently narrow so that substantially only one longitudinal mode 102A, 102B, 102C, ... can resonate.

A graph 106 corresponds to a resonant curve of DBR section 82, DBR section 82 is preferably written in device 72 so that its resonant curve substantially encloses only one of the peaks of graph 104, Thus in Fig. 6, longitudinal cavity mode 102K will resonate since it is within the resonant curve of the SSG, at $\lambda_B$, and section 82 is tuned to this wavelength. Modes such as 102J, 102H, and 102L will be substantially suppressed since they are on the wings of graph 106. As described above, DBR section 82 is tunable, so that for mode 102L to resonate the section is tuned to lower wavelength $\lambda_A$. Similarly, for modes 102H, 102F, and 102C to resonate, section 82 is respectively tuned to higher wavelengths $\lambda_C$, $\lambda_D$, $\lambda_E$. Thus system 70 can be effectively scanned from $\lambda_A$ to $\lambda_E$ by tuning DBR section 82 across the same wavelength range.

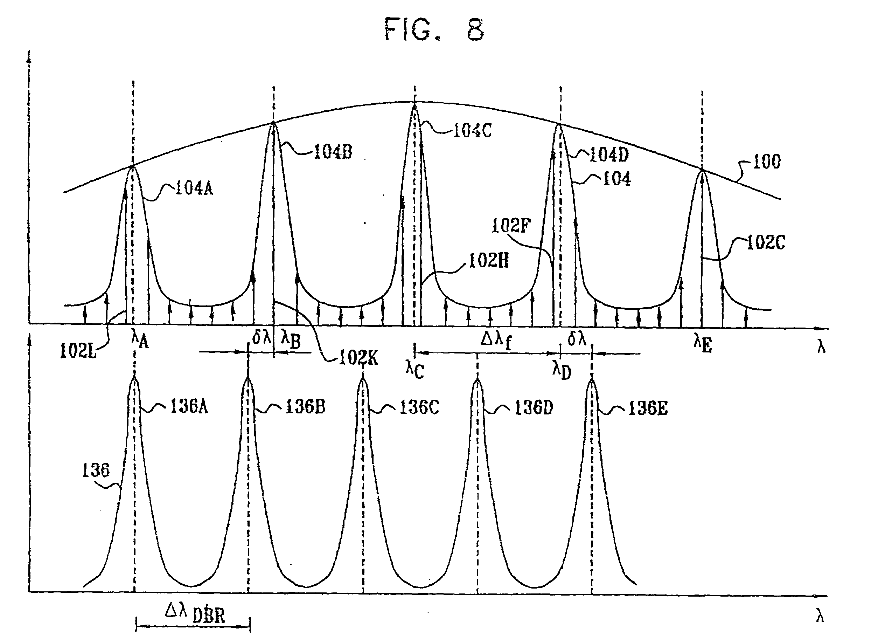

Fig. 7 is a schematic diagram of a laser system 120, according to a preferred embodiment of the present: invention. Apart from the differences described below, the operation of system 120 is generally similar to that of system 70 (Fig. 5), so that elements indicated by the same reference numerals in both systems 70 and 120 are generally identical in construction and in operation. Adjacent to facet 80 of device 72, region 76 comprises an SSG 124 implemented in a DBR section 122. SSG 124 comprises a plurality, preferably the same plurality as SSG 88, of gratings 124A, 124B, 124C, .... Most preferably, the separation between adjacent resonant peaks of SSG 124 is different from the separation between adjacent resonant peaks of SSG 88, and Lhe two separations are related in a vernier-like manner, as is described in more detail hereinbelow with reference to Fig. 8. Setting the separations to be different enables system 120 to be scanned over the whole range of wavelengths of SSG 88 using a reduced wavelength range scan of DBR section 122.

Fig. 8 shows schematic graphs of intensity vs. wavelength relationships for different elements of system 120, according to a preferred embodiment of the present invention, A graph 136 corresponds to a resonant reflection curve of DBR section 124. For clarity, graph 136 is shown separate, i.e., not overlaid, from graphs 100 and 104, Peaks 136A, 136B, 136C, ... of section 124 are assumed to be separated by a spacing $\Delta\lambda_{DBR}$, and peaks 104A, 104B, 104C, ... of SSG 88 are assumed to be separated by a different spacing $\Delta\lambda_F$. In general, if SSG 88 comprises j gratings each having a resonant wavelength separated by $\Delta\lambda_F$, and DBR section 124 comprises j spectral reflection peaks separated by $\Delta\lambda_{DBR}$, then the separations should be implemented so as to satisfy:

$$\Delta\lambda_{DBR} = \left(\frac{j-1}{j}\right)\cdot\Delta\lambda_F \qquad (6)$$

Setting $\Delta\lambda_F$ and $\Delta\lambda_{DBR}$ to be related according to equation (6) allows a vernier effect to be used to accomplish the tuning, as explained hereinbelow.

In the situation represented by Fig. 8, wherein by way of example j = 5, mode 102L will resonate, and other modes of system 102 will be substantially suppressed, since peak 136A is substantially aligned with peak 104A, and no other peaks of graphs 104 and 136 align. To tune system 120 to mode 102K, corresponding to peak 104B, curve 136 needs to move right by $\delta\lambda$, where

$$\delta\lambda = \Delta\lambda_F - \Delta\lambda_{DBR} \qquad (7)$$

so that peak 136B substantially aligns with peak 104B, and the other peaks of graphs 104 and 136 do not align.

Similarly, to tune system 120 to modes corresponding with peaks 104C, 104D, ..., curve 136 needs to move right by $2\delta\lambda$, $3\delta\lambda$, .... The resonant peaks of graph 136 should have narrow enough widths so that substantially only one longitudinal mode of system 120 lases at each of the alignments of curves 104 and 136, Thus, as illustrated by Fig. 8, system 120 can be effectively scanned from $\lambda_A$ to $\lambda_E$ by tuning section 124 by a total of $4\delta\lambda$.

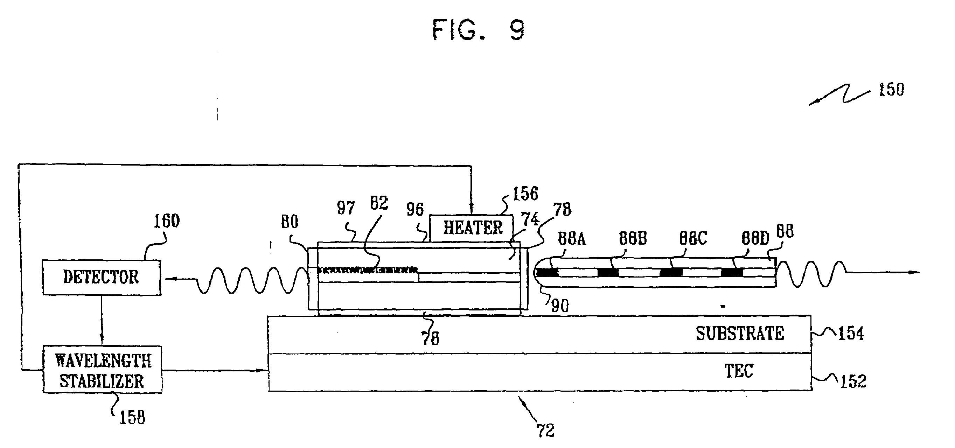

Fig. 9 is a schematic diagram of a system 150 for locking a longitudinal mode to an SSG peak, according to a preferred embodiment of the present invention. In implementing system 120 and system 70, it is necessary to adjust respective DBR sections 124 and 82 so that all modes in the respective SSG are suppressed apart from one. Most preferably, the position of the relevant cavity mode should be adjusted to correspond with the aligned peaks of the SSG and DBR section. Once adjusted, it is necessary to maintain the mode in position, It will be appreciated that effects such as temperature change, change in injected current, and mechanical changes will tend to move the peak of the mode relative to the peaks of the SSG and the DBR, causing mode hopping. System 150 is implemented for system 70, but the principles of system 150 apply also to system 120. The implementation of a system substantially similar to system 150 is described in detail in the above-referenced PCT patent application.

In system 150, system 70 is mounted on a substrate 154, beneath which is coupled a thermoelectric cooler (TEC) 1.52. Above electrode 96 of system 70 is mounted a heater 156. Heater 156 and TEC 152 may be adjusted either separatoly or together to alter temperatures of elements of cavity 84, and so change optical lengths of elements of the cavity. System 150 further comprises a detector 160 which measures a parameter of light output from cavity 84. Preferably, detector 160 measures the output from facet 80. Alternatively, detector 160 is positioned at another point, in system 150 where it is able to measure the parameter without substantially interfering with the operation of the system. Detector 160 supplies an error signal, generated responsive to the parameter output, to a wavelength stabilizer 158, which acts as a controller of heater 156 and TEC 152,

Referring back to Fig. 5, an effective length of cavity 84 is given by an equation:

$$L_{eff} = n_{DBR} \cdot L_{DBR} + n_g \cdot L_g + n_{SSG} \cdot L_{SSG} \qquad (8)$$

wherein

$n_{DBR}$ is a refractive index of DBR region 82;
$L_{DBR}$ is a length of region 82;
$n_g$ is a refractive index of gain region 76;
$L_g$ is a length of region 76;
$n_{SSG}$ is a refractive index of SSG 88; and
$L_{SSG}$ is an effective length of SSG 88.

Stabilizer 158 preferably modulates the temperature of one or more of DBR region 82, gain region 76, and SSG 88, so that their lengths and/or refractive indices, and thus the effective length $L_{eff}$ of cavity 84, are modulated. The modulation is performed by stabilizer 158 sending modulation signals to heater 156 and/or TEC 152. The parameter measured by detector 160 is a function of the modulation, such as a phase of the output compared to the modulating input, in which case the phase is used by detector 160 to generate the error signal. The error signal is used by stabilizer 158 as a negative feedback control so as to shift, as required, a mode of cavity 84 to an SSG 88 peak.

It will be appreciated that the preferred embodiments described above are cited by way of example, and that the present invention is not limited t:o what has been particularly shown and described hereinabove. Rather, the scope of the present invention includes both combinations and subcombinations of the various features described hereinabove, as well as variations and modifications thereof which would occur to persons skilled in the art upon reading the foregoing description and which are not disclosed in the prior art.

**Claims**

1.  A laser, comprising:

    a grating structure (88), comprising two or more gratings (88A, 88H, 88C, 88D) having a plurality of different wavelength peaks for reflection of optical radiation therefrom; and
    a semiconductor device (72), comprising an active region (76), which is operative to amplify the optical radiation, and a reflective region (82), which is adapted to reflect the optical radiation at a tunable resonant wavelength of the reflective region, the device being optically coupled to the grating structure so as to define a laser cavity (84) having a single cavity mode defined by tuning the resonant wavelength of the reflective region to overlap with one of the wavelength peaks of the grating structure.

2.  A laser according to claim 1, wherein the grating structure comprises a super structure grating (SSG) written in a fiber optic (86).

3.  A laser according to claim 2, wherein the fiber optic comprises a lens (90) which focuses optical radiation from the semiconductor device to the grating structure.

4.  A laser according to any of claims 1 - 3, wherein the two or more gratings are adapted to partially transmit optical radiation at the different wavelengths, so as to provide output optical radiation.

5.  A laser according to any of claims 1 - 4, wherein the reflective region comprises a Distributed Bragg Reflector (DBR) (82) written onto the semiconductor device, and wherein the resonant wavelength of the reflective region is tuned by a current injected into the DBR.

6.  A laser according to any of claims 1 - 5, wherein the plurality of different wavelength peaks are substantially equidistantly spaced by a first reparation, wherein the reflective region comprises a Distributed Bragg Reflector with a super structure grating (DBR-SSG) (124) having a plurality of different wavelength peaks substantially equidistantly spaced by a second separation different from the first separation, so that the first separation is related to the second separation in a vernier-like manner and so that the single cavity mode is defined when one of the grating structure wavelength peaks overlaps with one of the DBR-SSG wavelength peaks

7.  A laser according to any of claims 1 - 6, and comprising:

    an optical length changer (152, 156) which varies an optical length of at least one of a group of optical elements comprising the grating structure, the active region, and the reflective region, so as to vary accordingly an optical length of the laser cavity;
    a detector (160) which is adapted to monitor a level of the optical radiation responsive to the variation in the optical length of the at least one of the group; and
    a stabilizer (158) which responsive to the measured output from the detector supplies a control signal to the optical. length changer to control an optical length of at least one of the group, so that the laser cavity resonates stably in the single cavity mode,

8.  A laser according to claim 7, wherein the optical length changer comprises at least one of a thermally active group comprising a heater (156) and a thermoelectric cooler (152), and wherein the at least one of the thermally active group is adapted to alter a temperature of at least one of the group of optical elements.

9.  A method for generating a laser output, comprising:

    providing a grating structure (88) having a plurality of different wavelength peaks for reflection of optical radiation therefrom;
    optically coupling a semiconductor device (72) to the structure so as to define a laser cavity (84) between the structure and a reflective region (82) of the device, which is adapted to reflect the optical radiation aL a tunable resonant wavelength of the reflective region; and
    tuning the resonant wavelength of the reflective region to overlap with one of the wavelength peaks of the grating structure so as to generate a laser output in a single cavity mode defined by the overlap.

10. A method according to claim 9, wherein providing the grating structure comprises writing a super structure grating (SSG) in a fiber optic (86).

11. A method according to claim 9 or claim 10, wherein providing the grating structure comprises providing two or more gratings (88A, 88B, 88C) which are adapted to partially transmit optical radiation at the different wavelength peaks, so as to provide output optical radiation.

12. A method according to any of claims 9 - 11, wherein the reflective region comprises a Distributed Bragg Reflector (DBR) (82) written onto the semiconductor device, and wherein tuning the resonant wavelength of the reflective region comprises injecting a current into the DBR.

13. A method according to any of claims 9 - 12, wherein the reflective region comprises a Distributed Bragg Reflector with a super structure grating (DBR-SSG) (124) having a plurality of different DDR-SSG wavelength peaks substantially equidistantly spaced by a first separation, wherein providing the grating structure comprises substantially equidistantly spacing the plurality of different wavelength peaks by a second separation different from the first separation and related to the first separation in a vernier~like manner, and wherein tuning the resonant wavelength comprises overlapping one of the grating structure wavelength peaks with one of the DBR-SSG wavelength peaks

14. A method according to any of claims 9 - 13, and comprising:

varying with an optical length changer (152, 156) an optical length of at least one of a group of optical elements comprising the grating structure, an active region of the semiconductor device, and the reflective region, so as to vary accordingly an optical length of the laser cavity;

monitoring a level of the optical radiation responsive to the variation in the optical length of the at least one of the group; and

supplying a control signal to the optical length changer responsive to the monitored level so as to control an optical length of at least one of the group, so that the laser cavity resonates stably in the single cavity mode.

15. A method according to claim 14, wherein varying the optical length comprises altering a temperature of at least one of the group of optical elements using at least one of a thermally active group comprising a heater (156) and a thermoelectric cooler (152).

EP 1 130 718 A2

# FIG. 1
(PRIOR ART)

# FIG. 2
(PRIOR ART)

11

FIG. 3

(PRIOR ART)

FIG. 4

(PRIOR ART)

FIG. 5

FIG. 6

FIG. 7

FIG. 8

EP 1 130 718 A2

FIG. 9